Europäisches Patentamt

European Patent Office

Office européen des brevets

(19)

(11) Veröffentlichungsnummer : **0 544 128 B1**

(12) **EUROPÄISCHE PATENTSCHRIFT**

(45) Veröffentlichungstag der Patentschrift :
28.06.95 Patentblatt 95/26

(51) Int. Cl.$^6$ : **H03K 5/02**, H03F 3/45

(21) Anmeldenummer : **92118905.6**

(22) Anmeldetag : **04.11.92**

(54) **Schaltungsanordnung für eine Treiberschaltung.**

(30) Priorität : **25.11.91 DE 4138661**

(43) Veröffentlichungstag der Anmeldung :
**02.06.93 Patentblatt 93/22**

(45) Bekanntmachung des Hinweises auf die
Patenterteilung :
**28.06.95 Patentblatt 95/26**

(84) Benannte Vertragsstaaten :
**BE DE FR GB IT**

(56) Entgegenhaltungen :
**FR-A- 1 515 200**
**FR-A- 2 424 666**
**PATENT ABSTRACTS OF JAPAN vol. 4, no.**
**189 (E-039)25. Dezember 1980**
**PATENT ABSTRACTS OF JAPAN vol. 7, no.**
**033 (E-157)9. Februar 1983**

(56) Entgegenhaltungen :
**TELECOMMUNICATIONS AND RADIO ENGI-
NEERING Bd. 29/30, Nr. 9, September 1975,
Washington, US, Seiten 123 - 124, V. KRA-
KOVSKIY: 'Compensation of zero offset voltage in operational amplifiers'
PROCEEDINGS OF THE NATIONAL ELECTRO-
NICS CONFERENCE Bd. 25, Nr. 8-10, Dezember 1969, OAK BROOK, ILLINOIS US, Seiten
121 - 123 G. ERDI 'MINIMIZING OFFSET VOL-
TAGE DRIFT WITH TEMPERATURE IN MONO-
LITHIC OPERATIONAL AMPLIFIERS'**

(73) Patentinhaber : **SIEMENS
AKTIENGESELLSCHAFT
Wittelsbacherplatz 2
D-80333 München (DE)**

(72) Erfinder : **Rein, Hans-Martin, Prof. Dr.
Ein Bäumchen 6
W-5810 Witten (DE)**

EP 0 544 128 B1

## Beschreibung

Für schnelle digitale Übertragungssysteme und in der Meßtechnik werden vielfach Impulse mit verhältnismäßig großer Leistung benötigt, die möglichst symmetrisch bezüglich einer Umschaltschwelle sein sollen. Diese Impulse werden durch Treiberschaltungen erzeugt.

Treiberschaltungen umfassen vielfach Ausgangsstufen mit mindestens einem Differenzverstärker. Bei Betrieb der Treiberschaltung im Differenzbetrieb ist es verhältnismäßig leicht, Impulse zu erzeugen, die symmetrisch bezüglich der Umschaltschwelle sind. Diese Betriebsart ist jedoch für viele Anwendungen zu kompliziert.

Es gibt auch Anwendungen, in denen ein Differenzbetrieb nicht möglich ist. Eine Laserdiode in einem Sender von Glasfaserübertragungsstrecken kann z. B. nicht mit einer Treiberschaltung mit Differenzbetrieb angesteuert werden. Obwohl die Ausgangsstufe eines Lasertreibers meist durch einen begrenzenden Differenzverstärker gebildet wird, können zur Ansteuerung einer Laserdiode nur an einem der beiden komplementären Ausgänge des Differenzverstärkers Impulse abgenommen werden. Diese Betriebsart wird Single-ended genannt. Die Form von Impulsen bei Single-ended-Betrieb ist oft unsymmetrisch. In Schaltungen mit Bipolartransistoren ist die Form zwangsweise unsymmetrisch, da beim Einschaltvorgang der Ausgangstromimpuls einen deutlichen Überschwinger zeigt und außerdem die Flanke stärker verzögert als beim Ausschaltvorgang. Da der Kollektorstrom sein Vorzeichen nicht ändern kann, tritt gegen Ende des Ausschaltvorgangs kein Unterschwinger im Ausgangsstrom auf. Asymmetrische Impulse führen im Fall eines Lasertreibers dazu, daß wegen des auftretenden Zeit-Jitters die Länge einer ohne Repeater möglichen Übertragungsstrecke reduziert wird.

Es ist bekannt, die Symmetrie eines von einer Treiberschaltung im Single-ended-Betrieb erzeugten Impulses dadurch zu verbessern, daß die Treiberstufe mit kleineren Spannungshüben angesteuert wird. Dadurch wird allerdings die Flankensteilheit der Impulse verkleinert. Dieses führt dazu, daß die mögliche Datenrate reduziert wird.

Es ist weiter bekannt, die Symmetrie solcher Impulse durch eine Vorverzerrung der erzeugten Impulse durch passive Komponenten wie z. B. Filter zu verbessern. Dieses erfordert jedoch eine aufwendige Anpassung. Die Optimierung der passiven Komponenten ist überdies stark von der übertragenen Datenrate und von den Eigenschaften der Treiberschaltung und ihrer Belastung abhängig.

Eine weitere bekannte Möglichkeit besteht darin, die beiden komplementären Signale an den Ausgängen des Differenzverstärkers, bei gleichzeitiger Invertierung eines der beiden Signale zu einem symmetrischen Signal durch Verwendung hybrider Komponenten zu addieren (z. B. 180° Hybrid). Diese Maßnahme hat jedoch den Nachteil, daß sie sehr aufwendig und wenig flexibel ist. Dazu kommt, daß sie zu einer Begrenzung der Bandbreite führt, die häufig unerwünscht ist.

Der Erfindung liegt das Problem zugrunde, eine Schaltungsanordnung für eine Ausgangsstufe einer Treiberschaltung anzugeben, die ein symmetrisches Signal im Single-ended-Betrieb liefert, die einfach aufgebaut ist und leicht monolithisch integriert werden kann, und deren Ausgangsimpulsform einfach an die gegebenen Erfordernisse angepaßt werden kann. Die einmalige Einstellung der Impulsform soll für beliebige Impulsfolgen von sehr niedrigen bis zu sehr hohen Datenraten gelten, unter Beibehaltung steiler Impulsflanken. Außerdem soll der Ausgangshub leicht regelbar sein. Die Schaltungsanordnung soll insbesondere geeignet sein zum Betrieb einer Laserdiode in digitalen Übertragungssystemen und zur Erzeugung von Impulsen in der Meßtechnik.

Das Problem wird erfindungsgemäß gelöst durch eine Schaltungsanordnung nach Anspruch 1.

In der erfindungsgemäßen Schaltungsanordnung wird durch Anlegen der zweiten Off-set-Spannung an einem Eingang der zweiten Differenzverstärkerstufe ein Überschwinger in der Pulsform, der durch den Einschaltvorgang bedingt ist, reduziert. Das Vorzeichen der zweiten Off-set-Spannung wird dabei so gewählt, daß die Amplitude der Steuerspannung beim Einschalten des ersten Transistors, dessen Ausgangssignal für den Verbraucher interessiert, kleiner wird. Dadurch wird gleichzeitig die Amplitude der Steuerspannung beim Ausschalten größer. Auf diese Weise wird die Flankensteilheit des Ausgangsimpulses beim Einschalten gerade soweit reduziert, daß dieser Impuls einen ausreichend kleinen Überschwinger hat. Diese Maßnahme bewirkt außerdem, daß die bedingt durch die physikalischen Verhältnisse etwas langsamere Flanke beim Ausschalten steiler wird. Durch das Anlegen der zweiten Off-set-Spannung verschiebt sich die Symmetrie-Linie des Steuerimpulses, die durch die Mitte zwischen "High"- und "Low"-Pegel definiert ist, gegenüber der Null-Linie, bei der der Differenzverstärker umschaltet. Dadurch schneiden sich die ansteigende Flanke und die abfallende Flanke des Ausgangsimpulses nicht, wie erforderlich, in der Mitte zwischen "High"- und "Low"-Pegel. Durch Anlegen einer ersten Off-set-Spannung an einem Eingang der ersten Differenzverstärkerstufe ist das Tastverhältnis des von der ersten Differenzverstärkerstufe erzeugten Differenzsignals veränderbar, ohne daß sich die Ausgangspegel ändern. Da dieses Differenzsignal zur Ansteuerung der zweiten Differenzverstärkerstufe verwendet wird, werden auf diese Weise durch Veränderung des Tastverhältnisses des Differenzsignals

2

die ansteigende und die abfallende Flanke des Ausgangsimpulses zeitlich so verschoben, daß sie sich in der gewünschten Weise genau in der Mitte zwischen "High"- und "Low"-Pegel schneiden.

Die Einstellung der ersten Off-set-Spannungsquelle und der zweiten Off-set-Spannungsquelle kann über zwei Potentiometer erfolgen. Die Schaltungsanordnung kann damit auf einfache Weise an verschiedene Belastungen des Ausgangs angepaßt werden. Außerdem können Schwankungen in der Technologie, Ungenauigkeiten im Schaltungsentwurf und der Einfluß der durch die Aufbautechnik bedingten Parasiten (Bonddrähte, Gehäuse etc.) ausgeglichen werden.

Für eine vorgegebene Anwendung mit feststehenden Technologien und Aufbautechnik kann es zweckmäßig sein, an einen Ersatz dieser Potentiometer durch auf dem Chip integrierte Widerstände zu denken.

Die erfindungsgemäße Schaltungsanordnung ermöglicht symmetrische Impulsformen auch von Treiberstufen, die Differenzverstärker in Bipolartechnologie enthalten. Bei Verwendung von Bipolartransistoren sind Überschwinger aufgrund der physikalischen Verhältnisse nicht zu vermeiden, wenn gleichzeitig steile Pulsflanken angestrebt werden.

Die erste Differenzverstärkerstufe und die zweite Differenzverstärkerstufe umfassen jeweils eine Vorrichtung zur Pegelverschiebung und Entkopplung sowie einen ersten bzw. zweiten Differenzverstärker. Es liegt dabei im Rahmen der Erfindung, den ersten Differenzverstärker und den zweiten Differenzverstärker jeweils als begrenzende, emittergekoppelte Differenzverstärker vorzusehen, die kaskadiert sind. Die Vorrichtung zur Pegelverschiebung und Entkopplung umfaßt insbesondere drei hintereinander geschaltete Emitterfolgerpaare. Es können aber auch weniger Emitterfolgenpaare zur Anwendung kommen.

Zur Einstellung der Amplitude des Impulses an dem ersten Ausgang der zweiten Differenzverstärkerstufe ist es vorteilhaft, den zweiten Differenzverstärker und das vor den zweiten Differenzverstärker geschaltete Emitterfolgerpaar jeweils über eine regelbare Konstantstromquelle zu speisen. Durch Einstellung des Stroms an dem zweiten Differenzverstärker ändert sich die Amplitude des erzeugten Impulses. Um eine ungünstige Verformung des Impulses zu vermeiden, wird gleichzeitig der Strom an dem vor den zweiten Differenzverstärker geschalteten Emitterfolgerpaar so variiert, daß das Verhältnis der Ströme zueinander etwa konstant bleibt. Durch diese Maßnahme bleibt auch bei geänderter Amplitude die optimierte Pulsform und damit die Symmetrie des Ausgangsimpulses erhalten. Die Einstellbarkeit bzw. Regelbarkeit der Amplitude des Impulses ist besonders beim Betrieb von Laserdioden von Interesse, da Toleranzen der Laserdioden auszugleichen sind und außerdem die Laserdiode beim Altern einen höheren Impuls braucht.

Es liegt im Rahmen der Erfindung, den ersten Differenzverstärker und das vor den ersten Differenzverstärker geschaltete Emitterfolgerpaar jeweils über eine einstellbare Konstantstromquelle zu speisen. Durch Anpassung der Ströme durch den ersten Differenzverstärker und das vor den ersten Differenzverstärker geschaltete Emitterfolgerpaar kann die Pulsform des Ausgangssignals des zweiten Differenzverstärkers weiter beeinflußt werden. Auf diese Weise können Abhängigkeiten der Pulsform von Prozeß- und Designtoleranzen der Schaltungsanordnung sowie von Art der Belastung am Ausgang kompensiert werden. Insbesondere die Flankensteilheit und der Zeit-Jitter des Ausgangssignal können auf diese Weise weiter minimiert werden.

Wird der Verbraucher über eine Leitung mit dem Wellenwiderstand Z mit dem ersten Ausgang des zweiten Differenzverstärkers verbunden und hat der Verbraucher einen Widerstand $R_L$, So kann zwischen den Verbraucher und dem Ende der Leitung ein Widerstand der Größe $R_s = Z - R_L$ geschaltet werden. Auf diese Weise erfolgt ein reflexionsfreier Leitungsabschuß, solange $R_L$ ohmisch und frequenzunabhängig ist.

Wird als Verbraucher eine Laserdiode verwendet, so hat diese eine nichtlineare und frequenzabhängige Impedanz. Daher kann durch Zwischenschalten eines ohmischen Widerstandes $R_s$ die Anpassung nicht exakt sein. Um daraus resultierende Doppelreflexionen zu reduzieren, werden der erste Ausgang und, aus Symmetriegründen, auch der dazu komplementäre Ausgang des zweiten Differenzverstärkers jeweils mit einem Widerstand $R_Q$ abgeschlossen. Hier sind Kompromisse zu schließen. Es ist z. B. günstig, den Widerstand $R_Q$ so zu dimensionieren, daß der Reflexionskoeffizient an dem ersten Ausgang des zweiten Differenzverstärkers halbiert wird. In diesem Fall hält sich die mit dem Abschluß der Ausgänge verbundene Reduktion der Schaltgeschwindigkeit und die Erhöhung der Verlustleistung in annehmbaren Grenzen.

Im folgenden wird die Erfindung anhand eines Ausführungsbeispiels und der Figuren näher erläutert.

Fig. 1 stellt ein Blockschaltbild der erfindungsgemäßen Schaltung dar.

Fig. 2 stellt einen Schaltplan der erfindungsgemäßen Schaltungsanordnung dar.

Fig. 3 stellt den Einfluß der zweiten Off-set-Spannung auf das Signal am Eingang der zweiten Differenzverstärkerstufe dar.

Fig. 4 stellt den Einfluß der ersten Off-set-Spannung auf das Eingangssignal der Treiberschaltung dar.

Fig. 5 stellt das Ausgangsignal ohne und mit Anwendung der erfindungsgemäßen Offseteinstellung dar.

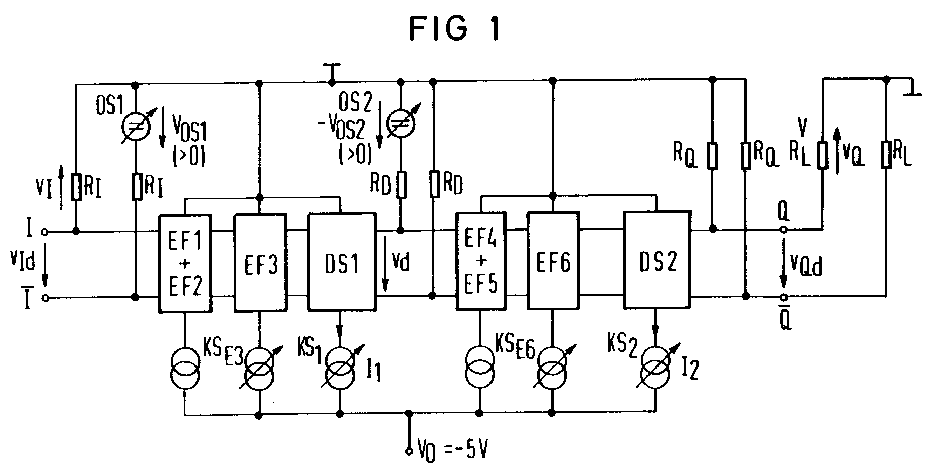

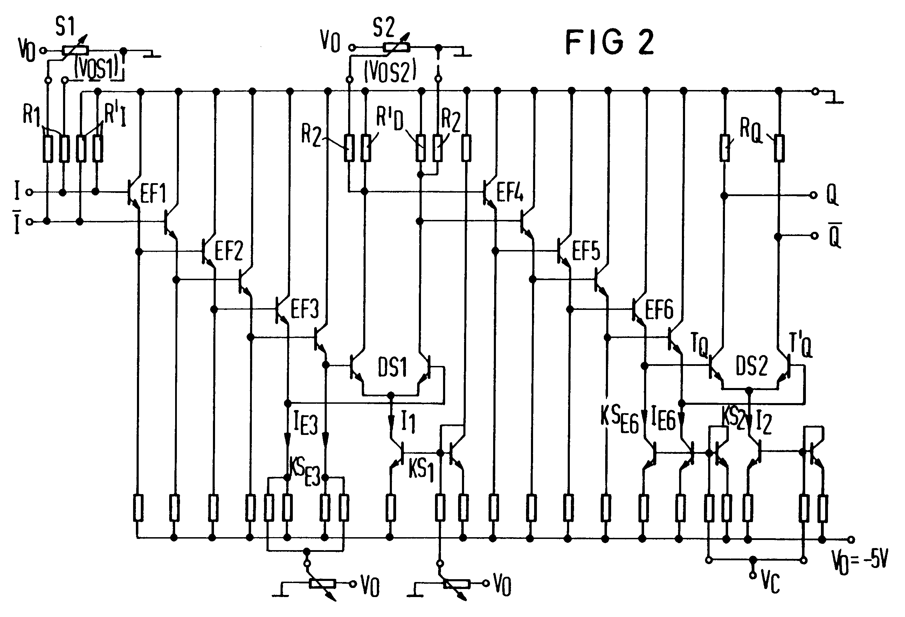

Um die Mißverständnisse zu vermeiden, sei zunächst darauf hingewiesen, daß die in Fig. 1 eingetragenen Offsetspannungen $V_{OS1}$ und $V_{OS2}$ der idealen Off-Set-Spannungsquellen OS1 und OS2 in dem Schaltplan nach Fig. 2 aus der Versorgungsspannung $V_o$ mit Potentiometern und den Serienwiderständen $R_1$ und $R_2$ abgeleitet

werden. Wegen $R_1 >> R_I^{'}$ und $R_2 >> R_D^{'}$ (s. Fig. 2) gilt $R_I \approx R_I^{'}$ und $R_D \approx R_D^{'}$ (s. Fig. 1).

Die Schaltungsanordnung enthält eine erste Differenzverstärkerstufe und eine zweite Differenzverstärkerstufe. Dabei umfaßt die erste Differenzverstärkerstufe ein erstes Emitterfolgerpaar EF1, ein zweites Emitterfolgepaar EF2, ein drittes Emitterfolgerpaar EF3 und einen ersten Differenzverstärker DS1 (s. Fig. 1). Die Emitteranschlüsse des ersten Emitterfolgerpaars EF1 sind mit den Basisanschlüssen des zweiten Emitterfolgerpaares EF2 verbunden. Die Emitteranschlüsse des zweiten Emitterfolgerpaares EF2 sind mit den Basisanschlüssen des dritten Emitterfolgerpaares EF3 verbunden. Die Emitteranschlüsse des dritten Emitterfolgerpaares EF3 sind jeweils mit den Basisanschlüssen des emittergekoppelten Transistorpaares des ersten Differenzverstärkers DS1 verbunden (s. Fig. 2).

Die erste Differenzverstärkerstufe umfaßt einen Eingang I und einen dazu komplementären Einang $\overline{I}$. Der komplementäre Eingang $\overline{I}$ ist über den äquivalenten Eingangswiderstand $R_I$ mit einer ersten (idealen) Off-set-Spannungsquelle OS1 verbunden (Fig. 1). Die Eingänge I und $\overline{I}$ sind jeweils mit den Basisanschlüssen des ersten Emitterfolgerpaares EF1 verbunden. Die Widerstände $R_I$ werden gegebenenfalls gleich dem Wellenwiderstand der ansteuernden Leitung gewählt (reflexionsfreier Leitungsabschluß).

Die Emitteranschlüsse des dritten Emitterfolgerpaares sind mit einer regelbaren Konstantstromquelle $KS_{E3}$ verbunden.

Der erste Differenzverstärker DS1 besteht z. B. aus einem Paar Bipolartransistoren, deren Emitteranschlüsse miteinander verbunden sind. Die Emitteranschlüsse des Transistorpaares des ersten Differenzverstärkers DS1 sind mit einer einstellbaren Konstantstromquelle $KS_1$ verbunden. Die Kollektoranschlüsse des Transistorpaares des ersten Differenzverstärkers DS1 bilden den Ausgang der ersten Differenzverstärkerstufe.

Die zweite Differenzverstärkerstufe umfaßt z. B. ein viertes Emitterfolgerpaar EF4, ein fünftes Emitterfolgerpaar EF5, ein sechstes Emitterfolgerpaar EF6 und einen zweiten Differenzverstärker DS2. Die Eingänge der zweiten Differenzverstärkerstufe werden durch die Basisanschlüsse des vierten Emitterfolgerpaares EF4 gebildet. Die Emitteranschlüsse des vierten Emitterfolgerpaares EF4 sind mit den Basisanschlüssen des fünften Emitterfolgerpaares EF5 verbunden. Die Emitteranschlüsse des fünften Emitterfolgerpaares EF5 sind mit den Basisanschlüssen des sechsten Emitterfolgerpaares EF6 verbunden. Die Emitteranschlüsse des sechsten Emitterfolgerpaares EF6 sind jeweils mit den Basisanschlüssen des aus einem ersten Transistor $T_Q$ und einem zweiten Transistor $T_Q^{'}$ gebildeten Transistorpaares des zweiten Differenzverstärkers DS2 verbunden.

Die Eingänge der zweiten Differenzverstärkerstufe sind jeweils mit den Ausgängen der ersten Differenzverstärkerstufe verbunden. Ein erster Eingang der zweiten Differenzverstärkerstufe ist über einen Widerstand $R_D$ mit einer zweiten (idealen) Off-set-Spannungsquelle OS2 verbunden (s. Fig. 1). Ein zweiter Eingang der zweiten Differenzverstärkerstufe ist über einen Widerstand $R_D$ mit Massepotential verbunden. Die Widerstände $R_D$ sind die Lastwiderstände des ersten Differenzverstärkers DS1.

Die Emitteranschlüsse des sechsten Emitterfolgerpaares EF6 sind mit einer regelbaren Konstantstromquelle $KS_{E6}$ verbunden. In der zweiten Differenzverstärkerstufe DS2 sind die Emitteranschlüsse des ersten Transistors $T_Q$ und des zweiten Transistors $T_Q^{'}$ miteinander verbunden. Die Emitteranschlüsse sind mit einer regelbaren Konstantstromquelle $KS_2$ verbunden. Die Konstantstromquelle $KS_{E6}$, die das sechste Emitterfolgerpaar EF6 speist und die Konstantstromquelle $KS_2$, die den zweiten Differenzverstärker DS2 speist, sind so miteinander verschaltet, daß bei einer Regelung des Stromes $I_2$ für den zweiten Differenzverstärker DS2 sich der Strom $I_{E6}$ für das sechste Emitterfolgerpaar EF6 so ändert, daß das Verhältnis $I_2/I_{E6}$ etwa konstant bleibt.

Die Kollektoranschlüsse des ersten Transistors $T_Q$ und des zweiten Transistors $T_Q^{'}$ bilden den ersten Ausgang Q und den dazu komplementären zweiten Ausgang $\overline{Q}$ der zweiten Differenzverstärkerstufe. Im Single-ended-Betrieb wird nur der erste Ausgang Q mit einem Verbraucher V belastet. Der Verbraucher V ist z. B. eine Laserdiode gegebenenfalls mit Serienwiderstand. Der erste Ausgang Q und der zweite Ausgang $\overline{Q}$ sind jeweils mit einem Widerstand $R_Q$ abgeschlossen, um bei Ansteuerung der Last über eine Leitung Doppelreflexionen zu reduzieren. Als sinnvollen Kompromiß kann $R_Q$ gleich dem doppelten bis dreifachen Wellenwiderstand der Leitung gewählt werden.

Die Widerstände $R_I^{'}$ und $R_D^{'}$ in Fig. 2 werden so dimensioniert, daß sie groß sind im Vergleich zu den Innenwiderständen der aus je einem Potentiometer und der Versorgungsspannung $V_o$ gebildeten ersten Off-set-Spannungsquelle S1 und zweiten externen Off-set-Spannungsquelle S2. Dadurch werden die von der ersten Spannungsquelle S1 und von der zweiten Spannungsquelle S2 abgeleiteten ersten Off-set-Spannung $V_{OS1}$ und zweiten Off-set-Spannung $V_{OS2}$ unabhängig von der Temperatur.

Neben der ersten Spannungsquelle S1 und der zweiten Spannungsquelle S2 umfassen auch die Konstantstromquellen $KS_{E3}$ und $KS_1$ Potentiometer. Damit können die erste Off-set-Spannung $V_{OS1}$, die zweite Off-set-Spannung $V_{OS2}$ und die Ströme $I_{E3}$ durch den dritten Emitterfolger EF3 und $I_1$ durch den ersten Differenzver-

stärker DS1 von außen eingestellt werden. Dagegen werden im Beispiel von Fig. 2 die Stromquellen $KS_{E6}$ und $KS_2$ durch eine gemeinsame externe Regelspannung $V_C$ angesteuert, wodurch die Ströme $I_{E6}$ durch das sechste Emitterfolgerpaar EF6 und $I_2$ durch den zweiten Differenzverstärker geregelt werden können.

Die Schaltungsanordnung wird mit einer Versorgungsspannung $V_O$ von -5 Volt betrieben.

Im Betrieb wird an die Eingänge der ersten Differenzverstärkerstufe ein Signal $v_{Id}$ angelegt. Das Signal $v_{Id}$ kann sowohl ein Differenzsignal als auch ein Single-ended-Signal sein. An den Ausgängen der ersten Differenzverstärkerstufe liegt ein Signal $v_d$ an. Mit dem Differenzsignal $v_d$ wird die zweite Differenzverstärkerstufe angesteuert. Am Ausgang der zweiten Differenzverstärkerstufe liegt zwischen dem ersten Ausgang Q und dem zweiten Ausgang $\overline{Q}$ ein Differenzsignal $v_{Qd}$. An dem ersten Ausgang Q liegt ein Single-ended-Signal $v_Q$. Dieses Signal wird zur Ansteuerung des Verbrauchers V verwendet.

Im Betrieb der Schaltungsanordnung wird zunächst die zweite Off-set-Spannung $V_{OS2}$ so eingestellt, daß die ursprünglich vorhandenen starken Unterschwinger des Single-ended-Signals $v_Q$, die durch die Überschwinger im Ausgangsstrom verursacht werden, weitgehend beseitigt sind. Dazu wird die zweite Off-set-Spannung $V_{OS2}$ so gewählt, daß die Amplitude der Steuerspannung beim Einschalten des ersten Transistors $T_Q$, der mit dem ersten Ausgang Q verbunden ist, kleiner wird. Beim Ausschalten wird die Amplitude der Steuerspannung des ersten Transistors dann größer. Anschließend wird die erste Off-set-Spannung $V_{OS1}$ so eingestellt, daß durch die damit verbundenen Änderungen des Tastverhältnisses des Differenzsignals $v_d$ die Flanken des Ausgangssignals $v_Q$ so verschoben werden, daß sie sich in der Mitte zwischen "High"- und "Low"-Pegel (d. h. auf der Symmetrie-Linie) schneiden. Es ist dazu erforderlich, daß die erste Off-set-Spannung $V_{OS1}$ und die zweite Off-set-Spannung $V_{OS2}$ zueinander entgegengesetzte Vorzeichen haben, falls die Definition dieser Spannung nach Fig. 1 zugrunde liegt.

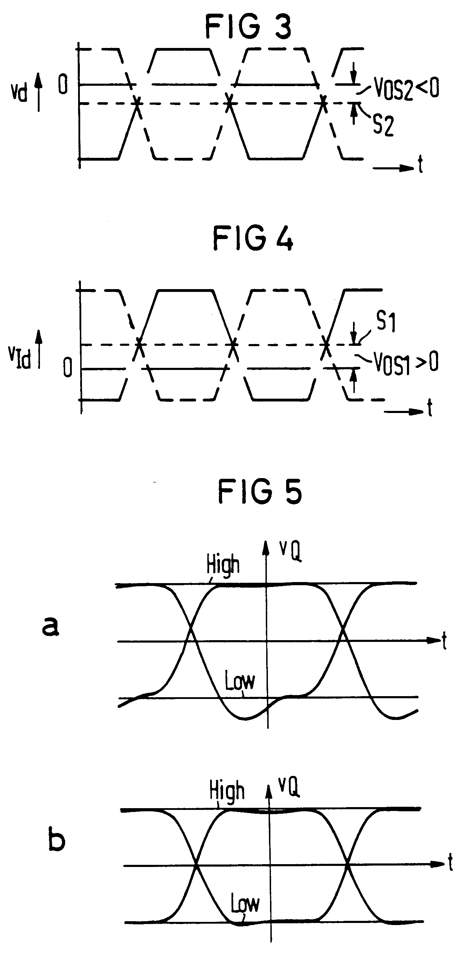

In Fig. 3 ist der qualitative Einfluß der zweiten Off-set-Spannung $V_{OS2}$ auf die Verschiebung der Symmetrie-Linie $S_2$ des Differenzsignals $v_d$ gegenüber der Null-Linie dargestellt.

In Fig. 4 ist der qualitative Einfluß der ersten Off-set-Spannung $V_{OS1}$ auf die Verschiebung der Symmetrie-Linie $S_1$ des Eingangssignals $v_{Id}$ gegenüber der Null-Linie dargestellt, wobei $v_{Id}$ in diesem Beispiel als Differenzsignal dargestellt ist.

Die Schaltungsanordnung wird z. B. realisiert unter Verwendung von Bipolartransistoren, die in einer selbstjustierten Doppel-Polysilizium-Technologie mit Grabenisolation (Trench-Isolation) unter Verwendung einer 0,8 µm-Lithographie hergestellt werden. Diese Bipolartransistoren haben eine effektive Emitterbreite von 0,4 µm.

Mit der erfindungsgemäßen Schaltungsanordnung und heute vorhandenen Bipolartechnologien können Impulsfolgen mit Datenraten bis zu 20 Gbit/s verarbeitet werden.

Fig. 5 zeigt die Simulationsergebnisse für eine solche integrierte Schaltung. In Fig. 5a ist das Augendiagramm des Ausgangssignals $v_Q$ für eine Datenrate von 10 Gbit/s angegeben, wobei die vorgeschlagenen Maßnahmen zur Einstellung der Off-set-Spannungen noch nicht ergriffen sind. Man erkennt die Unsymmetrie der Pulsform mit dem ausgeprägten Unterschwinger. Die erhebliche Verbesserung der Impulsform durch die erfindungsgemäßen Maßnahmen ist aus Fig. 5b ersichtlich.

**Patentansprüche**

1. Schaltungsanordnung für eine Ausgangsstufe einer Treiberschaltung,
   - bei der eine erste Differenzverstärkerstufe (EF1, EF2, EF3, DS1) und eine zweite Differenzverstärkerstufe (EF4, EF5, EF6, DS2) vorgesehen sind,
   - bei der die erste Differenzverstärkerstufe und die zweite Differenzverstärkerstufe jeweils zwei Transistoren, die nach Art eines Differenzverstärkertransistorpaares verschaltet sind, zwei zueinander komplementären Eingänge und zwei zueinander komplementäre Ausgänge umfassen,
   - bei der die erste Differenzverstärkerstufe mit einem Eingangssignal angesteuert wird und dabei ein Differenzsignal erzeugt,
   - bei der die zweite Differenzverstärkerstufe mit dem Differenzsignal angesteuert wird und dabei ein Ausgangssignal an einem ersten Ausgang und ein dazu komplementäres Ausgangssignal an einem zweiten Ausgang erzeugt,
   - bei der eine erste Off-set-Spannungsquelle (OS1) und eine zweite Off-set-Spannungsquelle (O52) vorgesehen sind, die einstellbar sind,
   - bei der die erste Off-set-Spannungsquelle (OS1) mit einem Eingang der ersten Differenzverstärkerstufe verbunden ist, so daß das Tastverhältnis des Differenzsignals durch Anlegen der ersten Off-set-Spannung veränderbar ist,
   - bei der die zweite Off-set-Spannungsquelle (OS2) mit einem Eingang der zweiten Differenzverstärkerstufe verbunden ist, so daß durch Anlegen der zweiten Off-set-Spannung die Einschaltspannung eines ersten Transistors der Transistoren der zweiten Differenzverstärkerstufe, der mit dem ersten Ausgang verbunden ist, erniedrigt werden kann, bei gleichzeitiger Erhöhung der Ausschaltspannung,

- bei der der erste Ausgang der zweiten Differenzverstärkerstufe mit einem Verbraucher (V) belastet ist.

2. Schaltungsanordnung nach Anspruch 1,
   - bei der die erste Differenzverstärkerstufe eine Vorrichtung zur Pegelverschiebung und Entkopplung (EF1, EF2, EF3) und einen ersten Differenzverstärker (DS1) umfaßt,
   - bei der die zweite Differenzverstärkerstufe eine Vorrichtung zur Pegelverschiebung und Entkopplung (EF4, EF5, EF6) und einen zweiten Differenzverstärker (DS2) umfaßt.

3. Schaltungsanordnung nach Anspruch 2,
   - bei der der erste Differenzverstärker (DS1) und der zweite Differenzverstärker (DS2) jeweils begrenzende, emittergekoppelte Differenzverstärker umfassen, die kaskadiert sind,
   - bei der die Vorrichtung zur Pegelverschiebung und Entkopplung jeweils mindestens ein in Reihe geschaltetes Emitterfolgerpaar (EF1, EF2, EF3) (EF4, EF5, EF6) umfaßt.

4. Schaltungsanorndung nach Anspruch 3,
   bei der der zweite Differenzverstärker (DS2) und das vor den zweiten Differenzverstärker (DS2) geschaltete Emitterfolgerpaar (EF6) jeweils über eine regelbare Konstantstromquelle ($KS_{E6}$, $KS_2$) gespeist werden.

5. Schaltungsanordnung nach Anspruch 4,
   bei der die regelbaren Konstantstromquellen ($KS_{E6}$, $KS_2$) so mit einer externen Spannungsquelle verbunden sind, daß die Ströme durch die regelbaren Konstantstromquellen ($KS_{E6}$, $KS_2$) über eine gemeinsame Spannung regelbar sind und dabei ein konstantes Verhältnis haben.

6. Schaltungsanordnung nach einem der Ansprüche 3 bis 5,
   bei der der erste Differenzverstärker (DS1) und das vor den ersten Differenzverstärker (DS1) geschaltete Emitterfolgerpaar (EF3) jeweils über eine einstellbare Konstantstromquelle ($KS_{E3}$, $KS_1$) gespeist werden.

7. Schaltungsanordnung nach einem der Ansprüche 1 bis 6,

   - bei der der Verbraucher (V) über eine Leitung mit dem Wellenwiderstand Z mit dem ersten Eingang (Q) des zweiten Differenzverstärkers (DS2) verbunden ist,
   - bei der zwischen den Verbraucher (V) und das Ende der Leitung ein Widerstand ($R_s$) der Größe $R_s$ = Z - $R_L$, wobei $R_L$ der Widerstand des Verbrauchers ist, geschaltet ist.

8. Schaltungsanordnung nach einem der Ansprüche 1 bis 7, bei der der Ausgang (Q) und der komplementäre Ausgang ($\overline{Q}$) des zweiten Differenzverstärkers (DS2) jeweils, zusätzlich zur externen Belastung mit einem Widerstand ($R_Q$) abgeschlossen sind.

9. Schaltungsanordnung nach einem der Ansprüche 1 bis 8, bei der der Verbraucher (V) eine Laserdiode ist.


## Claims

1. Circuit arrangement for an output stage of a driver circuit,
   - in which a first differential amplifier stage (EF1, EF2, EF3, DS1) and a second differential amplifier stage (EF4, EF5, EF6, DS2) are provided,
   - in which the first differential amplifier stage and the second differential amplifier stage in each case comprise two transistors, which are interconnected in the manner of a differential amplifier transistor pair, two mutually complementary inputs and two mutually complementary outputs,
   - in which the first differential amplifier stage is driven by an input signal and in the process generates a differential signal,
   - in which the second differential amplifier stage is driven by the differential signal and in the process

6

generates an output signal at a first output and an output signal complementary to this at a second output,

- in which a first offset voltage source (OS1) and a second offset voltage source (OS2), which are adjustable, are provided,
- in which the first offset voltage source (OS1) is connected to an input of the first differential amplifier stage, such that the duty ratio of the differential signal can be altered by applying the first offset voltage,
- in which the second offset voltage source (OS2) is connected to an input of the second differential amplifier stage, such that, by applying the second offset voltage, the turn-on voltage of a first transistor of the transistors of the second differential amplifier stage, which transistor is connected to the first output, can be reduced, the turn-off voltage simultaneously increasing,
- in which the first output of the second differential stage is loaded by a load (V).

2. Circuit arrangement according to Claim 1,
   - in which the first differential amplifier stage comprises a device for level shifting and decoupling (EF1, EF2, EF3) and a first differential amplifier (DS1),
   - in which the second differential amplifier stage comprises a device for level shifting and decoupling (EF4, EF5, EF6) and a second differential amplifier (DS2).

3. Circuit arrangement according to Claim 2,
   - in which the first differential amplifier (DS1) and the second differential amplifier (DS2) in each case comprise limiting, emitter-coupled differential amplifiers which are cascaded,
   - in which the device for level shifting and decoupling in each case comprises at least one series-connected emitter-follower pair (EF1, EF2, EF3) (EF4, EF5, EF6).

4. Circuit arrangement according to Claim 3, in which the second differential amplifier (DS2) and the emitter-follower pair (EF6) connected upstream of the second differential amplifier (DS2) are in each case fed by means of a controllable constant current source ($KS_{E6}$, $KS_2$).

5. Circuit arrangement according to Claim 4, in which the controllable constant current sources ($KS_{E6}$, $KS_2$) are connected to an external voltage source in such a way that the currents through the controllable constant current sources ($KS_{E6}$, $KS_2$) can be controlled by means of a common voltage and at the same time have a constant ratio.

6. Circuit arrangement according to one of Claims 3 to 5, in which the first differential amplifier (DS1) and the emitter-follower pair (EF3) connected upstream of the first differential amplifier (DS1) are in each case fed via an adjustable constant current source ($KS_{E3}$, $KS_1$).

7. Circuit arrangement according to one of Claims 1 to 6,
   - in which the load (V) is connected to the first input (Q) of the second differential amplifier (DS2) via a line having the characteristic impedance Z,
   - in which there is connected between the load (V) and the end of the line a resistor ($R_S$) of magnitude $R_S = Z - R_L$, where $R_L$ is the resistance of the load.

8. Circuit arrangement according to one of Claims 1 to 7, in which the output (Q) and the complementary output ($\overline{Q}$) of the second differential amplifier (DS2) are in each case terminated not only by the external load but also by a resistor ($R_Q$).

9. Circuit arrangement according to one of Claims 1 to 8, in which the load (V) is a laser diode.

**Revendications**

1. Montage pour un étage de sortie d'un circuit d'attaque,
   - dans lequel est prévu un premier étage amplificateur différenciateur (EF1, EF2, EF3, DS1) et un deuxième étage amplificateur différenciateur (EF4, EF5, EF6, DS2),
   - dans lequel le premier étage amplificateur différenciateur et le deuxième étage amplificateur différenciateur comprennent chacun deux transistors, qui sont connectés à la manière d'une paire de transistors d'amplificateur différenciateur, deux entrées complémentaires entre elles et deux sorties complémentaires entre elles,
- dans lequel le premier étage amplificateur différenciateur est commandé par un signal d'entrée et par cela génère un signal différentiel
- dans lequel le deuxième étage amplificateur différenciateur est commandé par le signal différentiel et par cela génère un premier signal de sortie à une première sortie et un signal de sortie complémentaire à celui-ci à une deuxième sortie,
- dans lequel sont prévues une première source de tension offset (OS1) et une deuxième source de tension offset (OS2), qui sont réglables,
- dans lequel la première source de tension offset (OS1) est reliée à une entrée du premier étage amplificateur différenciateur de façon à ce que le rapport cyclique du signal différentiel peut être varié par l'application de la première tension offset,
- dans lequel la deuxième source de tension offset (OS2) est relié à une entrée du deuxième étage amplificateur différenciateur de façon à ce que par l'application de la deuxième tension offset la tension de mise en circuit du premier transistor des transistors du deuxième étage amplificateur différenciateur, qui est relié à la première sortie, peut être abaissée tout en augmentant simultanément la tension de mise hors circuit,
- dans lequel la première sortie du deuxième étage amplificateur différenciateur peut être chargée par un consommateur (V).

2. Montage selon la revendication 1,
- dans lequel le premier étage amplificateur différenciateur comprend un dispositif pour le décalage des niveaux et pour le découplage (EF1, EF2, EF3) et un premier amplificateur différenciateur (DS1),
- dans lequel le deuxième étage amplificateur différenciateur comprend un dispositif pour le décalage des niveaux et pour le découplage (EF4, EF5, EF6) et un deuxième amplificateur différenciateur (DS2).

3. Montage selon la revendication 2,
- dans lequel le premier amplificateur différenciateur (DS1) et le deuxième amplificateur différenciateur (DS2) comprennent chacun des amplificateurs différenciateurs à couplage d'émetteur limitants, qui sont montés en cascade,
- dans lequel le dispositif pour le décalage des niveaux et pour le découplage comprend respectivement au moins une paire d'émetteur-suiveurs (EF1, EF2, EF3) (EF4, EF5, EF6) montée en série.

4. Montage selon la revendication 3, dans lequel le deuxième amplificateur différenciateur (DS2) et la paire d'émetteur-suiveurs (EF6) montée devant le deuxième amplificateur différenciateur (DS2) sont respectivement alimentés par une source de courant constant réglable ($KS_{E6}$, $KS_2$).

5. Montage selon la revendication 4, dans lequel les sources de courant constant réglables ($KS_{E6}$, $KS_2$) sont reliées à une source de tension externe de sorte que les courants à travers les sources de courant constant réglables ($KS_{E6}$, $KS_2$) sont réglables par une tension commune et présentent un rapport constant.

6. Montage selon l'une des revendications 3 à 5, dans lequel le premier amplificateur différenciateur (DS1) et la paire d'émetteur-suiveurs (EF3) montée devant le premier amplificateur différenciateur (DS1) sont respectivement alimentés par une source de courant constant réglable ($KS_{E3}$, $K_{S1}$).

7. Montage selon l'une des revendications 1 à 6,
- dans lequel le consommateur (V) est relié à la première entrée (Q) du deuxième amplificateur différenciateur (DS2) au moyen d'un conducteur ayant une impédance caractéristique Z,
- dans lequel entre le consommateur (V) et l'extrémité du conducteur est montée une résistance ($R_S$) d'une valeur de $R_S = Z - R_L$, $R_L$ étant la résistance du consommateur.

8. Montage selon l'une des revendications 1 à 7, dans lequel la sortie (Q) et la sortie complémentaire ($\overline{Q}$) du deuxième amplificateur différenciateur (DS2) sont en plus de la charge externe terminées chacune par une résistance ($R_Q$).

9. Montage selon l'une des revendications 1 à 8, dans lequel le consommateur (V) est une diode laser.

FIG 1

EP 0 544 128 B1

FIG 2

# FIG 3

# FIG 4

# FIG 5